# EUROPEAN PATENT APPLICATION

(11) **EP 0 654 545 A1**
(43) Date of publication of application: **24.05.1995**
(21) Application number: 94113308.4
(22) Date of filing: 25.08.1994
(51) Int. Cl.: C23C 16/40, H01L 21/316

(54) **Semiconductor device thin film formation method**

(30) Priority: 22.11.1993 JP 291926/93
(71) Applicant: APPLIED MATERIALS, INC., Santa Clara California 95052-8039 (US)
(72) Inventor: Mizuno, Shinsuke, Narita, Chiba 286 (JP)
(74) Representative: Kahler, Kurt, Dipl.-Ing.

(57) **Abstract**

A semiconductor device thin film formation method in which multiple ac power sources (8, 10) of differing frequencies or a power source of a single frequency is used to generate a plasma in a reactor vessel (2); by activating a reaction gas introduced to this reaction vessel (2) using plasma discharge energy, a deposit is formed by chemical growth of the reaction gas and deposited on a sample surface (5); a mixed gas of TEOS gas with a SiXₙR₄₋ₙ (where 1 ≦ n ≦ 3, Si is silicon, X is a halogen substituent, and R is an alkoxy group) silicon halide hydrocarbon gas is used as the reaction gas. This semiconductor device thin film forming method uses the PECVD method and is capable of greater densities.

## Description

### Industrial applications field

This invention relates to a method for forming thin film semiconductor devices using plasma enhanced CVD to form a thin film on a sample surface such as a semiconductor substrate, etc.

### Prior art

In the past, the plasma enhanced CVD method, whereby a plasma is produced in a reaction vessel, and the reaction gas introduced into this reaction vessel is activated using plasma discharge energy, thereby promoting the deposition of a deposit formed by chemical vapor growth of the reaction gas on the sample surface, was widely used as a means of forming a thin film on a semiconductor substrate or other sample surface.

In order to generate a plasma within the reaction vessel, methods used have included that in which a single frequency alternating current at 13.56 MHz, 400 kHz, etc., is applied between opposing electrodes erected within the reaction vessel, and said alternating current adjusted to control deposition speed and quality of the thin film formed, or the method whereby a 2.54 GHz microwave is guided to the reaction vessel through a waveguide.

Gases used for the reaction gas included for the deposition of SiO₂ and SiON on the surface of a semiconductor substrate are, for example TEOS (tetraethyl orthosilicate) gas and SiH₄ gas.

### Problems to be solved by the invention

In keeping with the demand in recent years for the realization of VLSI, the development of fine formation technology at submicron levels has taken on extreme importance. By experimentally verifying the shapes of thin films formed by conventional plasma-enhanced CVD methods, we have investigated the potential for submicronization using conventional techniques.

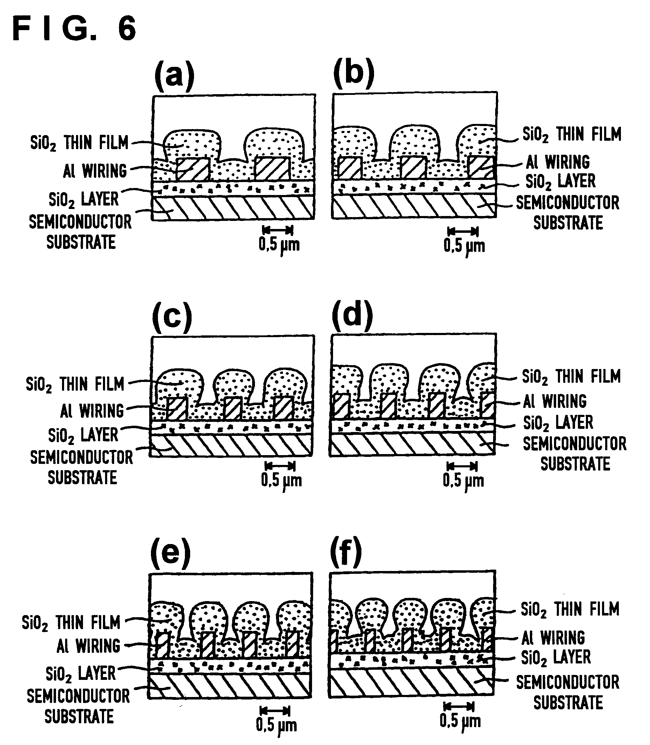

Figures 6 (a) - (f) show the vertical sectional shape obtained when, in a conventional plasma-enhanced CVD (referred to below as PECVD), which generates a plasma in a reaction vessel by applying a 13.56 MHz single frequency power between the above opposing electrodes, the introduction of SiH₄ gas causes an insulating covering of SiO₂, to be formed on the SiO₂ oxide layer on the semiconductor substrate surface and Al wiring formed on that surface. For purposes of explanation, we shall refer to the bottom side of the SiO₂ thin film which is supposed to be formed for example, the above-mentioned SiO₂ film and Al wiring portion as the foundation.

As is clear from these experimental results, the SiO₂ thin film has a sectional shape in which that side has ridges and roundness following the depressions and ridges of the foundation surface. In other words, as a result of the fact that the film thickness is greater in the region of the Al wiring upper side than in the region of the Al wiring lower side, the problem arises that voids are created in the region of the lower side of the Al wiring. This invites an extremely serious problem in high density wiring (see Figures 6 (e) and (f)) when the space between voids in Al wiring grows very small, as in the submicron [environment].

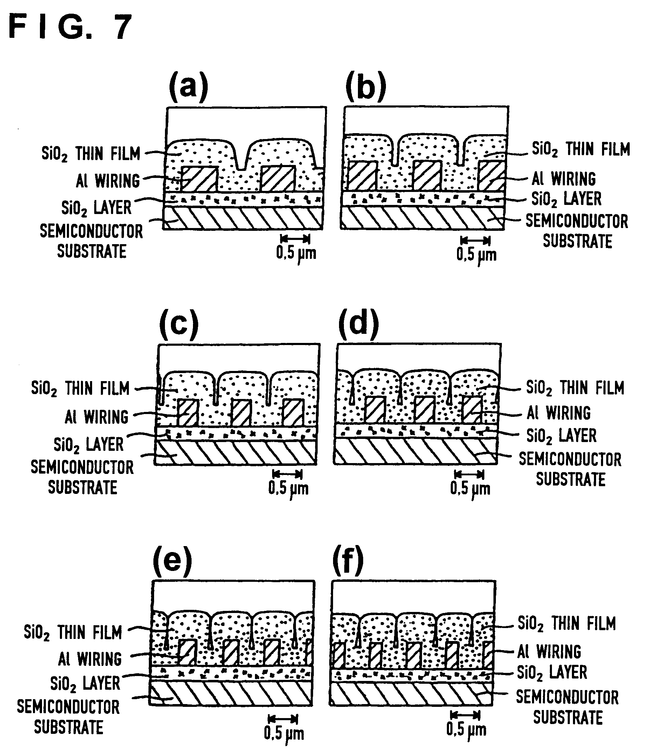

Figures 7 (a) - (f) depict the experimental results (vertical section) of the case where, in a conventional two frequency excitation-type PECVD equipment, wherein a plasma is generated in a reaction vessel by simultaneously applying a high frequency power of 13.56 MHz and a low frequency power of 400 kHz between the aforementioned opposing electrodes, the introduction of a TEOS gas causes an SiO₂ thin film to act as an insulating covering to be further formed on the semiconductor substrate surface SiO₂ oxide film and on the Al wiring formed on the surface thereof (in other words, on top of the foundation).

Details on the technology of simultaneously applying a 13.56 MHz high frequency alternating current and a 400 kHz low frequency alternating current are disclosed in Japanese Kokoku Patent No. Sho 59[1984]-30130; it is held that high speed thin film formation and an improvement in quality can be achieved by applying these two frequencies of alternating current.

In these experimental results, as is clear from Figures 7 (a) - (f), roundness is absent from the side wall portion of the SiO₂ thin film here formed when compared to the experimental results shown in Figures 6 (a) - (f), meaning that a reduction in voids has been achieved. We may say that this technology has contributed greatly to improving the controllability of thin film formation.

However, as is shown in Figures 7 (e) and (f), slit-shaped voids remain with high density thin film formation at the submicron level, where the interlead spacing in the Al wiring becomes narrow. That is, we have confirmed that the reduction of voids is not adequate with the conventional technology, and that it will be difficult to handle the requirements of greater densities this way.

The purpose of this invention is to offer a semiconductor device thin film formation method which takes note of the problems inherent in this conventional PECVD method, and which is capable of handling ever higher densities.

### Means to solve the problem

In order to achieve these objectives, the invention has as its object a semiconductor device thin film forming method characterized as follows:
multiple alternating current power sources of differing frequencies or a power source of a single frequency are used to generate a plasma in a reactor vessel;
by activating a reaction gas introduced to this reaction vessel using plasma discharge energy, a deposit is formed by chemical growth of the reaction gas on a sample surface, and, as the above reaction gas, the invention applies a mixed gas of TEOS gas with a SiXₙR₄₋ₙ, (where 1 ≦ n ≦ 3, Si is silicon, X is a halogen substituent, and R is an alkoxy group) silicon halide hydrocarbon gas.

More specifically, in an actual implementation of the invention, the "X" halogen substituent in the above halogen carbide hydrocarbon gas is one of the following:
fluorine "F",
chlorine "Cl", or
bromine "Br",
and the alkoxy base "R" above is one of the following:
hydrogen "H",
methoxy "OCH₃",
ethoxy "OC₂H₅",
n-propoxy "OC₃H₇",
i-propoxy "OCH(CH₃)₂",
n-butoxy "OC₄H₉",
i-butoxy "OCH₂CH(CH₃)₂",
s-butoxy "OC(CH₃)C₂H₅", or
t-butoxy "OC(CH₃)₃)".

A representative example of the general formula shown above for the silicon halide hydrocarbon gas would be SiF(OC₂H₅)₃, made up of fluorine "F" for the above halogen substituent "X" and ethoxy "OC₂H₅" as the above alkoxy group "R".

### Function

When a thin film is formed on the rough surface of the foundation material using TEOS gas and silicon halide hydrocarbon gas as the above reaction gases, the side walls of the thin film will be formed in a regularly tapered shape in conformance with that roughness; the thin film will favorably invade and be finely formed in the depressions thereof, so that even if the surface of the foundation material is rough, the surface of the thin film will be flat. In other words, the side walls of the thin film are not formed in a reverse tapered manner, but display superior filling characteristics, so voids do not form in the depression of the foundation material. Also, because of the excellent fineness of the above side walls, it is possible to offer a method with superior film quality controllability. Furthermore, because the thin film formed includes halogen elements such as fluorine in the film, making it low in electrical inductance, it becomes possible to improve the electrical characteristics of transistors, etc.

### Brief explanation of the figures

- Fig. 1: is a diagram explaining the principles of a PECVD device used in explaining an application example of the semiconductor device thin film forming method of the invention;
- Fig. 2: is a vertical section showing the shape of the SiO₂ thin film formed using the mixture of TEOS gas and silicon halide hydrocarbon gas as the reaction gas with the PECVD device depicted in Figure 1;
- Fig. 3: is an evaluation table showing the results of an evaluation based on an experiment with the SiO₂ thin film of the application example and a conventional technology SiO₂ thin film;
- Fig. 4: is a diagram explaining an embodiment of the invention in the case where an ECR plasma CVD device is used;
- Fig. 5: is a diagram explaining an embodiment of the invention in the case where an induction coupled RF high density plasma CVD device is used;
- Fig. 6: is a vertical section showing the shape of an SiO₂ thin film formed by the conventional PECVD method; and
- Fig. 7: is a vertical section showing the shape of an SiO₂ thin film formed by the conventional PECVD method.

### Application example

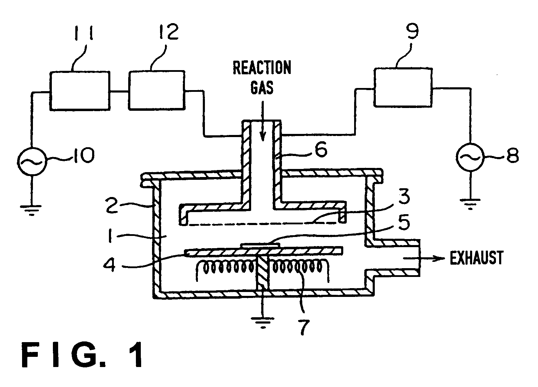

Below we shall explain an application example of the invention with diagrams. First, based on Figure 1, we shall explain the principles of the PECVD equipment used in this application example. Opposing electrodes 3 and 4 are housed in insulating reaction vessel 2 used to implement reaction chamber 1, which is sealed from the atmosphere. One of these electrodes 4 is held at ground potential while a semiconductor substrate 5 for thin film formation is affixed to the opposite surface; the power used to generate a plasma is applied to the other electrode 3. The reaction gas is introduced from the upper side of electrode 3 through pipe 6 to reaction chamber 1, while the inside of reaction chamber 1 is put into a condition of negative pressure by exhausting one side of reactor vessel 2. There is also a heater 7 provided on the electrode 4 side for purposes of temperature control.

Further, a high frequency power of, for example, 13.56 MHz is applied from high frequency power supply 8 to electrode 3 through impedance matching circuit 9, while at the same time a low frequency power of, for example, 400 kHz is applied from low frequency power supply 10 to electrode 3 through impedance matching circuit 11 and high frequency cutoff filter circuit 12, which prevents the passing of the high frequency component. That is to say, by simultaneously applying two frequencies of alternating current to electrode 3, a plasma is generated in reaction chamber 1.

In the PECVD equipment thus constituted, the reaction gas described below (a mixed gas) is introduced into reaction chamber 1, the output power ratio of high frequency power supply 8 and low frequency power supply 10 are adjusted to activate this reaction gas with plasma discharge energy, and a SiO₂ film is formed on the surface of semiconductor substrate 5.

A mixture of TEOS gas and silicon halide hydrocarbon gas is used as the above reaction gas. This silicon halide hydrocarbon gas is expressed by the general formula SiXₙR₄₋ₙ (where 1 ≦ n ≦ 3; Si is silicon, X is a halogen substituent and R is an alkoxy group); the "X" halogen substituent in the above halogen carbide hydrocarbon gas is one of the following:
fluorine "F", chlorine "Cl", and bromine "Br", and the alkoxy group "R" is one of the following:
hydrogen "H", methoxy "OCH₃", ethoxy "OC₂H₅", n-propoxy "OC₃H₇", i-propoxy "OCH(CH₃)₂", n-butoxy "OC₄H₉", i-butoxy "OCH₂CH(CH₃)₂", s-butoxy "OC(CH₃)C₂H₅)", and t-butoxy "OC(CH₃)₃)".

As the typical example of general formula SiXₙR₄₋ₙ, for example, the silicon halide hydrocarbon gas in which the alide substituent (C) is fluorine (F) and the alkoxy group (R) is ethoxy (OC₂H₅) is SiF(OC₂H₅)₃.

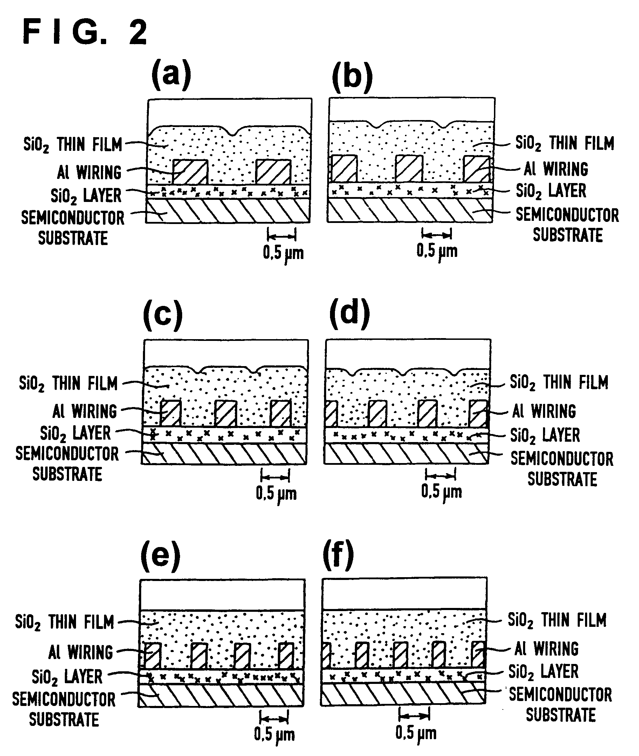

Figures 2 (a) - (f) depict a vertical section of the case where a SiO₂ thin film is formed as an insulating cover over the foundation material on top of the semiconductor substrate surface SiO₂ oxide film and the Al wiring formed thereon which is to say on a rough surface by the formation manufacturing stage which makes use of a mixture (reaction gas) of TEOS gas and silicon halide hydrocarbon gas, for example a mixture of the above TEOS gas with a SiF (OC₂H₅)₃ gas. In this diagram, the section has been traced from the contours of a micrograph taken of the vertical section; the height and width are as depicted by the unit scale (0.5 µm) included in the diagram.

As Figures 2 (a) - (d) show, the surface layer (surface) of the SiO₂ thin film is somewhat rough in conformance with the roughness of the foundation material when the interstitial spacing within the Al wiring is relatively large, but because of the superior filling characteristics displayed with respect to depressions in the foundation material, that surface is flat when compared to the conventional technology (see Figures 6 and 7). Furthermore, even if the surface of that SiO₂ thin film is somewhat rough owing to the roughness of the foundation material, the sloped side walls of those depressions and ridges are formed with a regular taper, so the occurrence of voids is greatly reduced.

As Figure 2 (e) shows, even when the Al wiring interstitial spacing is in the submicron range, filling characteristics with respect to depressions in the foundation material are superior, so the SiO₂ thin film surface is flat, and the occurrence of voids is greatly reduced. When the Al wiring interstitial spacing gets even smaller in the submicron range, as shown in Figure 2 (f), the SiO₂ thin film fills in between the Al wires, and the problem of voids is completely eliminated.

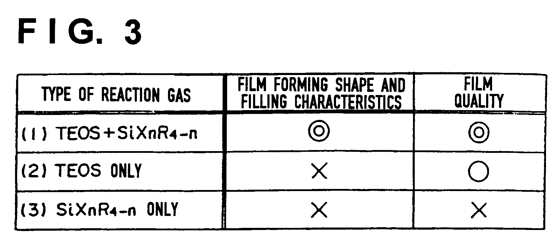

Figure 3 shows the results of an evaluation of film shape and filling characteristics versus film quality using the same manufacturing equipment using (1) a mixture of TEOS gas and silicon halide hydrocarbon gas per the invention, (2) conventional TEOS gas only, and (3) silicon halide hydrocarbon only. In this evaluation table, "X" indicates that favorable results were not obtained; a single "O" indicates relatively favorable results, and a double "ⓞ" indicates superior results.

The point to be noted in this embodiment is that, as shown in Figures 2 (a) - (d), whether the widths of an interstitial spacing between each of the Al wiring [leads] are relatively wide, or as shown in Figure 2 (e) and (f) they are in the submicron range, the SiO₂ thin film favorably invades and densely fills the depressions in the roughness caused by the Al wiring. Furthermore, regardless of the fine manufacturing conditions, because of the superior filling characteristics achieved, there is no occurrence of voids in the depressions on the foundation material. The fact that the fineness of the SiO₂ thin film is favorable means that it is possible to offer a method with superior film quality controllability. Furthermore, because the thin film formed includes halogen elements such as fluorine in the film, making it low in electrical inductance, it becomes possible to improve the electrical characteristics of transistors, etc.

In this embodiment we have explained the case using the two frequency excitation-type PECVD equipment whose principle is depicted in Figure 1, but the invention is not limited to this, and an equivalent effect can also be obtained by forming the thin film using a single-excitation type PECVD equipment, which generates a plasma with a single frequency alternating current to activate a mixture (reaction gas) of the above-described TEOS gas and silicon halide hydrocarbon gas with this plasma discharge energy. That is, regardless of the type of plasma excitation high frequency alternating current, the superior thin film formation described above can be achieved by using the reaction gas of the invention.

The same superior thin film formation can also be achieved by applying the reaction gas of the invention using ECR plasma CVD equipment, induction coupled RF high density plasma CVD equipment, helicon wave RF high density plasma CVD equipment, etc.

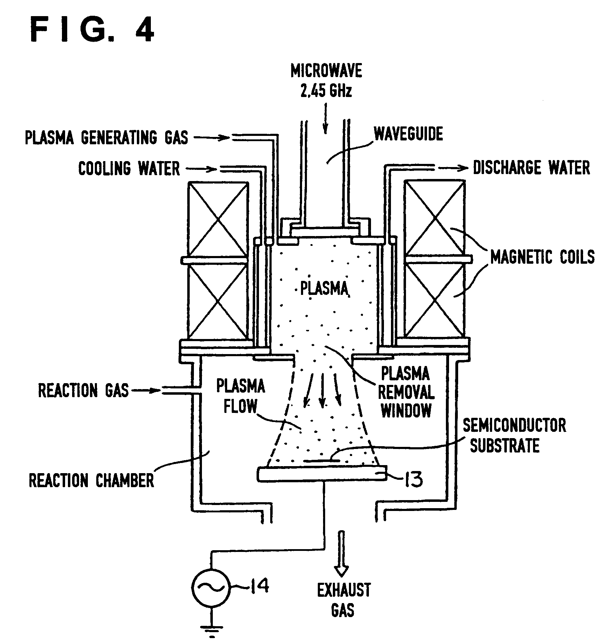

For example, when the reaction gas of the invention is used with ECR plasma CVD equipment, a 2.45 GHz microwave, for example, is guided through a waveguide to the plasma generation chamber in the ECR plasma CVD equipment which is outlined in Figure 4. At the same time the gas used for generating a plasma (N₂) is introduced to the reaction chamber, and the various gas mixtures described above are introduced to the reaction chamber as reaction gases. The thin film which is to be formed on a semiconductor substrate, etc., is then formed on the attaching electrode 13 by applying a high frequency power, for example of 13.56 MHz, from high frequency power supply 14.

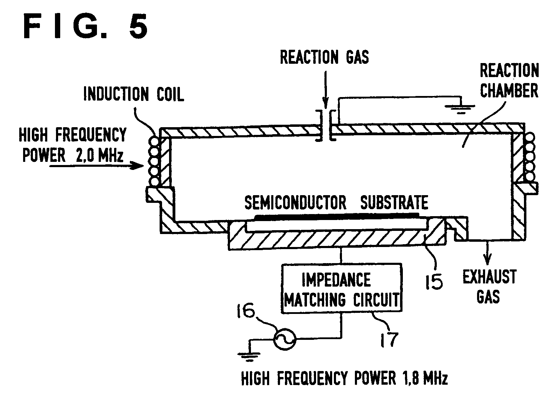

When the reaction gas of the invention is used with induction coupled RF high density plasma CVD equipment, a plasma is formed by a high frequency power of, for example, 2.0 MHz supplied to the induction coil in the reaction chamber of the induction coupled RF high density plasma CVD equipment whose outline is shown in Figure 5, while at the same time the reaction gas of the invention is introduced to the reaction chamber. The thin film which is to be formed on a semiconductor substrate, etc., is then formed on the attaching electrode 15 by the application of a high frequency power of, for example 1.8 MHz from high frequency power supply 16 through impedance matching circuit 17.

### Effect of the invention

The invention as described above provides a method whereby multiple alternating current power sources of differing frequencies or a power source of a single frequency are used to generate a plasma in a reactor vessel; by activating a reaction gas introduced to this reaction vessel using plasma discharge energy, a deposit is formed by chemical growth of the reaction gas to be deposited on a sample surface; in this method a mixture of TEOS and silicon halide hydrocarbon gases are used for the reaction gas, so even when the thin film is formed on the surface of foundation material with a rough surface, there is no occurrence of voids, since the side walls and surface walls of the thin film are flat. Because of the favorable fineness of the thin film, it is possible to offer a method with superior film quality controllability. Furthermore, because the thin film formed includes halogen elements such as fluorine in the film, making it low in electrical inductance, it becomes possible to improve the electrical characteristics of transistors, etc. Thus, a semiconductor device thin film forming method may be offered which can respond to ever increasing densities.

## Claims

1. A semiconductor device thin film formation method in which multiple alternating current power sources of differing frequencies or a power source of a single frequency are used to generate a plasma in a reactor vessel; and
by activating a reaction gas introduced to this reaction vessel using plasma discharge energy, a deposit is formed by chemical growth of the reaction gas on a sample surface;
**characterized** by
the fact that it makes use for the above reaction gas of a mixed gas of TEOS gas with a SiXₙR₄₋ₙ (where 1 ≦ n ≦ 3, Si is silicon, X is a halogen substituent, and R is an alkoxy group) silicon halide hydrocarbon gas.

2. The semiconductor device thin film formation method of claim 1,
**characterized** by
the fact that the "X" halogen substituent in the above halogen carbide hydrocarbon gas is one of the following:
fluorine "F",
chlorine "Cl", or
bromine "Br",
and the alkoxy group "R" above is one of the following:
hydrogen "H",
methoxy "OCH₃",
ethoxy "OC₂H₅",
n-propoxy "OC₃H₇",
i-propoxy "OCH (CH₃)₂",
n-butoxy "OC₄H₉",
i-butoxy "OCH₂CH(CH₃)₂",
s-butoxy "OC(CH₃)C₂H₅)", or
t-butoxy "OC(CH₃)₃)".
